(19)

**Europäisches Patentamt**
**European Patent Office**
**Office européen des brevets**

(11) **EP 4 644 995 A2**

(12) **EUROPEAN PATENT APPLICATION**

(43) Date of publication:
**05.11.2025 Bulletin 2025/45**

(21) Application number: **25173129.5**

(22) Date of filing: **29.04.2025**

(51) International Patent Classification (IPC):
**G03F 9/00** (2006.01)

(52) Cooperative Patent Classification (CPC):
**G03F 9/7092**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **01.05.2024 JP 2024074512**

(71) Applicant: **CANON KABUSHIKI KAISHA**
**Tokyo 146-8501 (JP)**

(72) Inventor: **KOMUKAI, Akifumi**
**Tokyo, 146-8501 (JP)**

(74) Representative: **TBK**
**Bavariaring 4-6**
**80336 München (DE)**

(54) **SUBSTRATE PROCESSING METHOD, SUBSTRATE PROCESSING APPARATUS, AND ARTICLE MANUFACTURING METHOD**

(57)    A substrate processing method includes performing prealignment of a substrate, and performing fine alignment of the substrate after the performing the prealignment, wherein the performing the prealignment includes calculating a plurality of amounts of positional deviation of the substrate in parallel by a plurality of methods, and the performing the fine alignment includes deciding a detection range of a mark formed on the substrate based on the plurality of calculated amounts of positional deviation.

**F I G. 1**

EP 4 644 995 A2

## Description

TECHNICAL FIELD

The present disclosure relates to a substrate processing method, a substrate processing apparatus, and an article manufacturing method.

BACKGROUND

In a semiconductor manufacturing apparatus, alignment of a substrate is performed before substrate processing (for example, exposure processing and inspection processing). As a step for alignment, there is a step called a prealignment (coarse alignment). This step is a step of performing coarse alignment of a substrate before it is processed on a substrate stage such that the amount of positional deviation of the substrate conveyed and placed on the substrate stage falls within a predetermined range.

In an exposure apparatus, prealignment is performed to align a substrate for which a lithography step (exposure step) has never been performed and decide the position of a pattern to be formed (an underlying pattern when executing the next exposure step). Prealignment is also performed for previous alignment to send a substrate for which an exposure step has already been executed once or more to form a mark for substrate position measurement to the visual field of a measuring device such as an image processing device that performs alignment at a high accuracy required in the exposure step.

In the conventional technique, however, if the substrate outer shape detection accuracy is low, or there is a laminating error of a laminated substrate, the prealignment accuracy may lower. In a case where the prealignment accuracy lowers, when the substrate is placed on the stage, a registration mark formed on the substrate may not enter the visual field of the measuring device. In this case, throughput lowers because it is necessary to perform a search for causing the registration mark to enter the visual field of the measuring device.

SUMMARY

The present disclosure in its first aspect provides a substrate processing method as specified in claim 1. Optional features are specified in claims 2-8.

The present disclosure in its second aspect provides a substrate processing apparatus as specified in claim 9. Optional features are specified in claim 10.

The present disclosure in its third aspect provides an article manufacturing method as specified in claim 11.

Further features of the present disclosure will become apparent from the following description of exemplary embodiments with reference to the attached drawings.

BRIEF DESCRIPTION OF THE DRAWINGS

Fig. 1 is a view showing the configuration of a substrate processing apparatus;
Fig. 2 is a view showing the configuration of a prealignment unit;
Fig. 3 is a view showing an example of the output waveform of a light receiving element to a silicon substrate;
Fig. 4 is a view showing an example of the output waveform of the light receiving element to a chamfered transparent substrate;
Fig. 5 is a view showing an example of the output waveform of the light receiving element to a laminated substrate;
Fig. 6 is a view exemplarily showing the relationship between the rotation angle of a substrate and the detected position of the edge of the substrate;
Fig. 7 is a flowchart showing an alignment method;
Fig. 8 is a view showing an example of mark expectation ranges;
Fig. 9 is a view showing an example of a detection range including a plurality of mark expectation ranges;
Fig. 10 is a view showing an example of a mark detection execution range; and
Fig. 11 is a view showing the configuration of an exposure apparatus.

DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

In the specification and the accompanying drawings, directions will be indicated on an XYZ coordinate system in which directions parallel to the holding surface of a substrate stage (to be described later) for holding a substrate are defined as the X-Y plane, unless specifically mentioned. Directions parallel to the X-axis, the Y-axis, and the Z-axis of the XYZ coordinate system are the X direction, the Y direction, and the Z direction, respectively. A rotation about the X-axis, a rotation about the Y-axis, and a rotation about the Z-axis are $\theta X$, $\theta Y$, and $\theta Z$, respectively. Control or driving concerning the X-axis, the Y-axis, and the Z-axis means control or driving concerning a direction parallel to the X-axis, a direction parallel to the Y-axis, and a direction parallel to the Z-axis, respectively. In addition, control or driving concerning the $\theta X$-axis, the $\theta Y$-axis, and the $\theta Z$-axis means control or driving concerning a rotation about an axis parallel to the X-axis, a rotation about an axis parallel to the Y-axis, and a rotation about an axis parallel to the Z-axis, respectively. In addition, a position is information that can be specified based on coordinates on the X-, Y-, and Z-axes, and a posture is information that can be specified by values on the $\theta X$-, $\theta Y$-, and $\theta Z$-axes.

<First Embodiment>

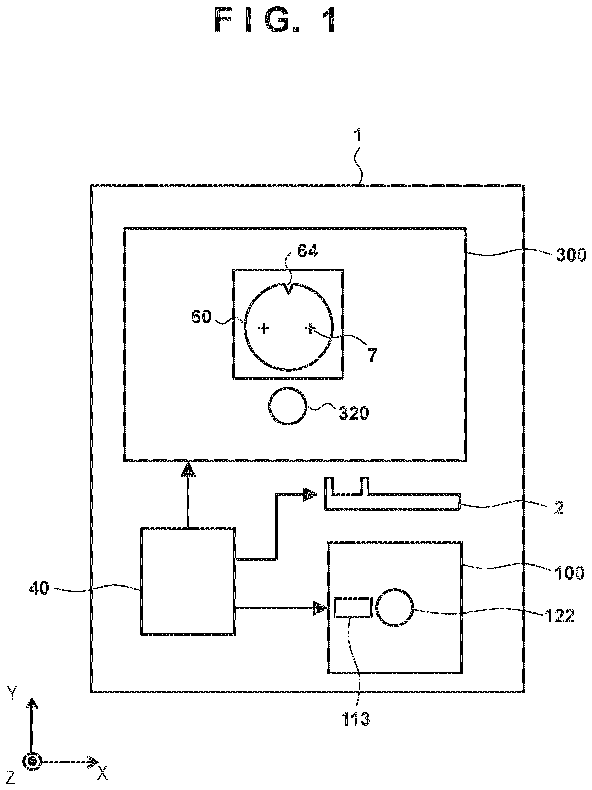

The configuration of a substrate processing apparatus 1 according to the first embodiment will be described with reference to Fig. 1. The substrate processing apparatus 1 shown in Fig. 1 includes a prealignment unit 100 that performs first-stage alignment (prealignment), a substrate conveying mechanism 2 configured to convey a substrate, a processing section 300 that processes the substrate, and a control device 40. The control device 40 controls the prealignment unit 100, the substrate conveying mechanism 2, and the processing section 300. The processing section 300 can perform second-stage alignment (fine alignment) for the substrate prealigned by the prealignment unit 100. Hence, the processing section 300 may be called a fine alignment unit.

A substrate 60 is conveyed to the prealignment unit 100 by a substrate conveying robot (not shown). The prealignment unit 100 includes a prealignment stage 110 and an outer shape detection device 120. The prealignment unit 100 performs first-stage alignment of the substrate 60 using the prealignment stage 110 and the outer shape detection device 120. In this specification, "alignment" is locating a substrate to a predetermined position concerning at least a translation direction and a rotation direction.

After the prealignment unit 100 performs first-stage alignment, the substrate 60 is conveyed to the processing section 300 by the substrate conveying mechanism 2. The processing section 300 includes a substrate stage 310 and a mark detector 320 (detection unit). The substrate stage 310 is a stage that holds and moves the substrate 60. Marks 7 for registration are formed on the substrate 60. The mark detector 320 detects the marks 7 on the substrate. The substrate stage 310 is driven based on the detection result of the marks 7 and performs second-stage alignment to align the substrate to a position where predetermined processing is executed for the substrate 60.

In this embodiment, the substrate 60 has a V- or U-shaped notch 64 on the outer periphery to indicate a direction. Not the notch but an orientation flat may be formed on the substrate 60. However, if a method of performing direction detection without depending on the notch or orientation flat is employed, the notch or orientation flat may not be formed on the substrate. Also, in this embodiment, the material of the substrate, transparency, the presence/absence of a laminating process, and the like are not particularly limited.

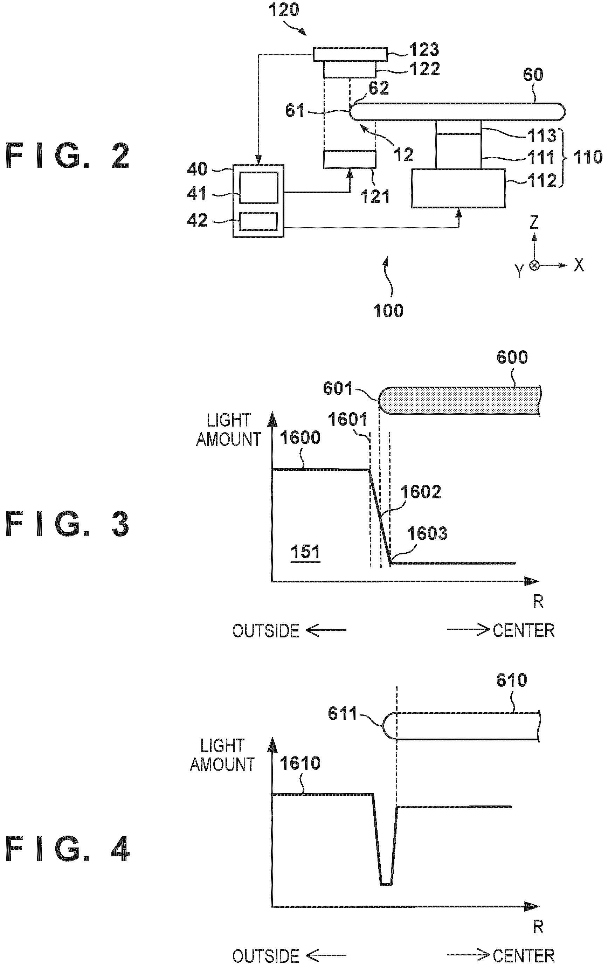

The configuration of the prealignment unit 100 will be described next with reference to Fig. 2. Fig. 2 is a side view of the prealignment unit 100 in a state in which the substrate 60 is conveyed onto the prealignment stage 110. Before the substrate 60 is conveyed to the substrate stage 310 where second-stage alignment and predetermined processing are performed, the prealignment unit 100 detects the position of the substrate 60, and aligns the substrate 60 to a predetermined standby position based on the detection result.

The prealignment stage 110 can include a rotation stage 111 that rotates the substrate 60 in the $\theta Z$ direction, an XY stage 112 that translates the substrate 60 in the XY plane, and a support portion 113 that supports the substrate 60.

The outer shape detection device 120 can include a light source 121 arranged at a position on the reverse surface side of the substrate 60. The outer shape detection device 120 can further include an optical system 122 and a light receiving element 123, which are arranged at positions above the light source 121 and on the obverse surface side of the substrate 60. The light source 121 is, for example, an LED light source. The light receiving element 123 is, for example, an image capturing element such as a CCD or a CMOS sensor. The light source 121 performs light irradiation such that at least an edge 61 that is the boundary between the substrate 60 and a space on the outer peripheral side is included in the irradiation range. The light receiving element 123 receives, via the optical system 122, light from the light source 121, which has passed through the space outside the substrate 60 (the space for which light is not shielded for the substrate 60). In addition, if the substrate 60 is a transparent substrate, the light receiving element 123 receives light that has passed through the space outside the substrate 60 and light transmitted through the substrate 60.

Note that the light source 121 is preferably bright-field illumination. By using not dark-field illumination but bright-field illumination, even if a chamfer 62 is formed near the edge 61 of the substrate 60 to remove angles, it is possible to prevent the measuring accuracy of the edge 61 from lowering due to the influence of reflected light on the chamfer 62.

The control device 40 can include a controller 41 and a storage unit 42. The controller 41 can be formed by, for example, a computer (information processing apparatus) including a processor such as a central processing unit (CPU) and a memory. The control device 40 is connected to the light receiving element 123. The controller 41 is configured to perform an operation to detect the edge 61 of the substrate from the light receiving result of the light receiving element 123 and obtain the position of the substrate 60. The control device 40 is also connected to the light source 121 and can control its brightness. The control device 40 is also connected to the prealignment stage 110 and controls driving of the rotation stage 111 and the XY stage 112.

The storage unit 42 of the control device 40 stores information necessary for a registration operation. For example, the position of the substrate 60 obtained by the controller 41 (including the position in the rotation direction as well), the light amount of the light source 121, and the like can be stored. The control device 40 may include a plurality of controllers 41 and storage units 42. If there are a plurality of controllers and storage units, these may be integrated in one housing, or may be distributed to a plurality of points unless the functions are impaired.

Outer shape detection of the substrate by the controller 41 will be described with reference to Figs. 3 to 5. Fig. 3 shows the relationship between a substrate 600 and the output waveform (received light waveform 1600) of the light receiving element 123 that is the substrate outer shape information when the substrate outer shape (edge) exists in the visual field of the light receiving element 123. The abscissa indicates a radial direction position R of the substrate 600, and the ordinate indicates the received light amount.

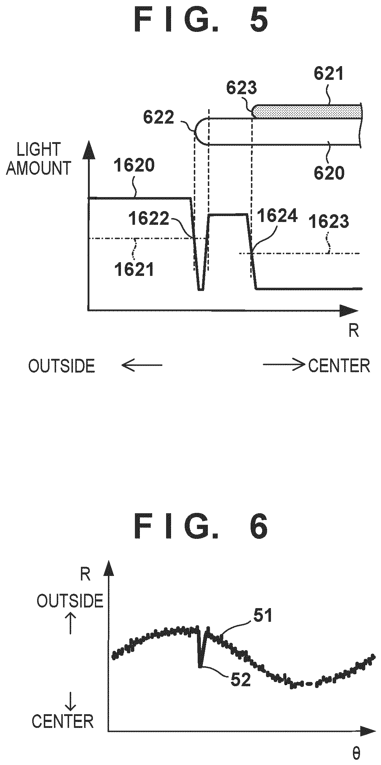

If the substrate 600 shown in Fig. 3 is a substrate that does not pass light, like a silicon substrate, light from the light source 121 is shielded from a substrate edge 601. Hence, the received light waveform 1600 as shown in Fig. 3 is obtained. If a substrate 610 shown in Fig. 4 is a substrate that passes light, like a glass substrate, and is a substrate having undergone chamfering, after light from the light source 121 is shielded at a substrate edge 611, the light transmitted through the substrate 610 is received. Hence, a received light waveform 1610 as shown in Fig. 4 is obtained. Also, in a case of a substrate (to be referred to as a "laminated substrate" hereinafter) in which a silicon substrate 621 is laminated onto a glass substrate 620, as shown in Fig. 5, after light from the light source 121 is shielded at an edge 622 of the glass substrate 620, the light transmitted through the glass substrate 620 is received, and the light from the light source 121 is then shielded again from an edge 623 of the silicon substrate 621. Hence, a received light waveform 1620 as shown in Fig. 5 is obtained. Thus, the received light waveform changes depending on the transparency/opacity of the substrate, the presence/absence of a laminating process, and the like.

Methods for detecting the edge of the substrate will be described based on the above-described finding. In an example of the edge detection method, a first change point 1601 of the light amount can be determined as an edge based on the received light waveform 1600 of the silicon substrate (substrate 600) shown in Fig. 3. Also, a point 1603 where the change of the light amount starts may be determined as an edge. Furthermore, an intermediate point 1602 between the point 1601 and the point 1603 may be determined as an edge. Also, in Fig. 5, a point 1622 where the light amount falls below a predetermined threshold 1621 of the light amount for the first time can be determined as an edge. Alternatively, a point 1624 where the light amount falls below a threshold 1623 of the light amount for the second time may be determined as an edge. Using these methods, the outer shapes of the substrates that form the laminated substrate can separately be detected from one received light waveform. The edge detection methods are not limited to the above-described methods and are arbitrary.

The controller 41 applies the edge detection to the whole outer periphery (all rotation angles) of the substrate, thereby obtaining a position waveform 51 indicating the position of the substrate outer periphery and a notch shape 52 as shown in Fig. 6. In Fig. 6, the abscissa indicates a rotation angle $\theta$ (a rotation angle in the $\theta Z$ direction) of the substrate, and the ordinate indicates the position R of the detected edge of the substrate 60. The steep change point 52 on the graph corresponds to a notch 64 of the substrate. The deviation amount ($\Delta\theta$) of the rotation angle of the substrate 60 can be calculated based on the steep change point 52. In addition, an eccentricity amount ($\Delta XY$) of the center of the substrate 60 with respect to the rotation center (origin) of the rotation stage 111 can be calculated based on the amplitude of the position waveform 51. $\Delta\theta$ and $\Delta XY$ will be referred to as "amounts of positional deviation" hereinafter. The amounts of positional deviation can include information of the amount ($\Delta\theta$) of rotation and amount ($\Delta XY$) of translation. Since $\Delta\theta$ and $\Delta XY$ are amounts that should be adjusted (compensated for) by prealignment concerning the rotation angle and the center position, respectively, $\Delta\theta$ and $\Delta XY$ may be called prealignment adjustment amounts.

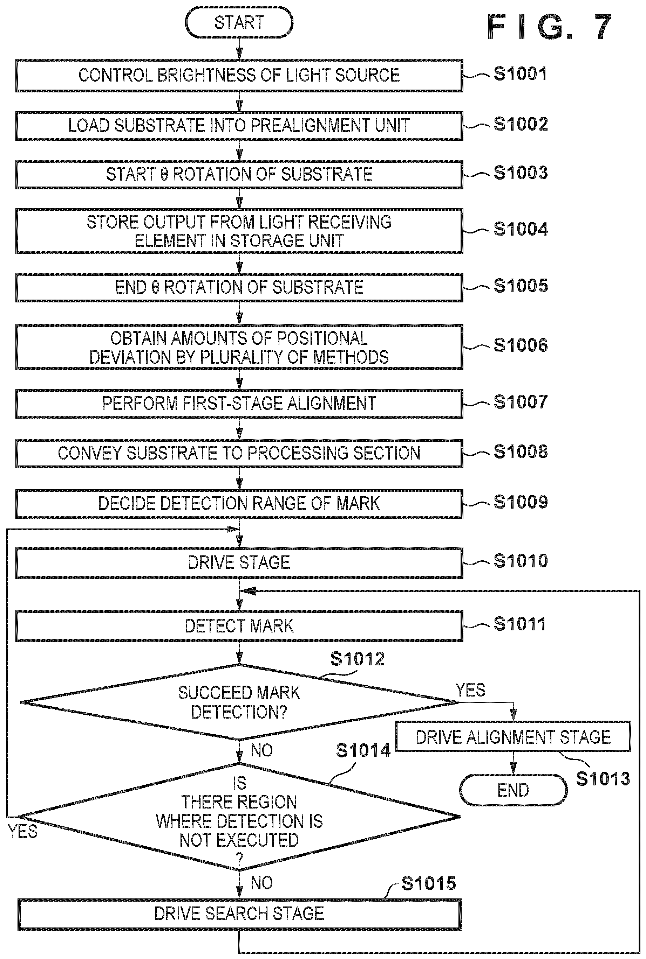

An alignment method (substrate processing method) of the substrate processing apparatus 1 will be described next with reference to Fig. 7. Fig. 7 is a flowchart showing the procedure of registration of the substrate 60 using the substrate processing apparatus 1. Steps S1001 to S1007 correspond to a prealignment step, and steps S1008 to S1013 correspond to a fine alignment step.

In step S1001, the controller 41 controls the brightness of the light source 121. Note that the brightness of the light source 121 is preferably controlled in a state in which the substrate 60 that is a light shielding object does not exist in the substrate processing apparatus 1. This is because if the brightness is controlled in a state in which the substrate 60 exists on the optical path, the light amount in a portion where the light is shielded by the substrate 60 cannot be confirmed, and the signal strength may exceed an allowable value during the rotation operation of the substrate 60.

In step S1002, the controller 41 controls a conveying robot (not shown) to load the substrate 60 into the prealignment unit 100. The loaded substrate 60 is placed on the support portion 113 and fixed on the support portion 113 by a vacuum suction mechanism (not shown). Since registration is not performed yet at this stage, the substrate 60 is deviated in the translation direction and the rotation direction with respect to a desired position.

In step S1003, the controller 41 controls the rotation stage 111 to rotate the substrate 60. During rotation of the rotation stage 111, the light receiving element 123 receives light from the light source 121. In step S1004, the controller 41 sequentially receives the output from the light receiving element 123, and stores it in the storage unit 42. After rotating the substrate 60 by an amount (360°) necessary for registration, the controller 41 ends the rotation operation by the rotation stage 111 (step S1005). The output of the light receiving element 123 for each rotation angle of the substrate 60 is thus acquired, and a received light waveform that is the outer shape information of the substrate 60 is obtained.

In step S1006 (calculation step), the controller 41 performs edge detection of the substrate 60 using a plurality of methods for the received light waveform corresponding to one round of the outer periphery, thereby obtaining a plurality of amounts ($\Delta\theta$ and $\Delta XY$) of positional deviation calculated in parallel by the plurality of methods. Here, between the plurality of methods, for example, a criterion to determine which part of the received light waveform is an edge may be different. Alternatively, for example, the edge determination method itself is the same between the plurality of methods, but the threshold may be different. Alternatively, between the plurality of methods, whether to perform preprocessing for noise removal for the received light waveform may be different, or the contents of the preprocessing may be different. Practical edge detection methods of the plurality of methods and the classification standard of the plurality of methods are arbitrary.

In step S1007, the controller 41 performs first-stage alignment of the substrate 60 based on one of the plurality of amounts ($\Delta\theta$ and $\Delta XY$) of positional deviation obtained in step S1006. The first-stage alignment is performed by rotating ($\theta$ direction) and horizontally moving (X and Y directions) the substrate holding mechanism 113 by the rotation stage 111 and the XY stage 112. Also, the first-stage alignment is performed by further controlling the rotation stage 111 and the XY stage 112 such that the center of the substrate 60 is located at a target position such as the origin of the prealignment stage 110. In step S1008, the controller 41 controls the substrate conveying mechanism 2 to convey the prealigned substrate 60 to the substrate stage 310 of the processing section 300.

Next, second-stage alignment (fine alignment) is performed. In the second-stage alignment, the mark 7 on the substrate 60 needs to be detected. To detect the mark 7 on the substrate 60, in step S1009, the controller 41 decides the detection range of the mark 7 (decision step). Here, the designed position and size of the mark 7 on the substrate 60 are known. The controller 41 calculates a plurality of candidates (mark position candidates) of the existence position of the mark 7 based on the designed position of the mark 7 and the plurality of amounts ($\Delta\theta$ and $\Delta XY$) of positional deviation obtained in step S1006, and decides a region including the plurality of mark position candidates as a detection range. Note that the "detection range" can include information of a position and a size on the substrate where detection by the mark detector 320 is performed. Since the visual field of the mark detector 320 is larger than the size of the mark 7, the size of the visual field of the mark detector 320 is the "detection range". At this time, the "detection range" is set to an arbitrary area. For example, considering an error, a region including the vicinity of the mark 7 may be set as the "detection range".

In step S1010, the controller 41 performs XY driving of the substrate stage 310 (alignment of the substrate) based on the decided detection range (for example, such that the detection range or a part thereof enters the visual field of the mark detector 320). XY driving of the substrate stage 310 is executed such that, for example, detection is performed with priority on a position calculated as a position where the mark 7 exists in the region decided as the detection range. In step S1011, the controller 41 detects the mark 7 on the substrate 60 using the mark detector 320 (scope).

In step S1012, the controller 41 determines whether mark detection succeeds. If mark detection succeeds (YES in step S1012), the process advances to step S1013. In step S1013, based on the mark detection result using the mark detector 320, the controller 41 calculates errors of translation ($\Delta XY$) and rotation ($\Delta\theta$) with respect to the target position of the substrate 60. After that, the controller 41 rotates ($\theta$ direction) and horizontally moves (X and Y directions) the substrate stage 310 based on the calculated errors, thereby finally aligning the substrate 60 to the desired position.

In step S1011, even if the mark detector 320 observes the mark 7 on the substrate 60 placed on the substrate stage 310, the mark 7 may be off the visual field of the mark detector 320 (NO in step S1012). Normally, when obtaining the center of the substrate, calculation is performed assuming that a portion other than a notch or orientation flat is circular, and the substrate has a size complying with the standard. In fact, however, even if the notch or orientation flat is excluded, the substrate is not circular but distorted. Also, as for the size of the substrate, even in a case of, for example, a 12-inch substrate, the size varies on an order of several hundred $\mu$m in a lot. Furthermore, the accuracy of obtained outer shape data changes depending on the type of the substrate or the edge detection method for the substrate. Also, in a case of the substrate shown in Fig. 5, in which the silicon substrate 621 is laminated onto the glass substrate 620, the laminating error between the substrates is a factor for making the mark 7 located outside the visual field of the mark detector 320. In a case of the laminated substrate, prealignment is preferably executed by detecting the edge 623 of the surface with the mark 7 formed thereon (in this case, the silicon substrate 621). However, in the laminated substrate, a foreign substance may adhere to the glass substrate 620, or an adhesive used for laminating may protrude, and it is sometimes impossible to accurately detect the edge 623. Under such circumstances, the accuracy of the substrate position detected based on the edge 623 is low. Alternatively, it may be impossible to perform edge detection at an accuracy necessary for calculation of the substrate position in the first place. Hence, under such a circumstance, prealignment may be executed using the edge 622 of the glass substrate. If a laminating error between the substrates exists in this case, the mark 7 may not enter the visual field of the mark detector 320 at the time of second-stage alignment.

If mark detection fails, for example, upon determining that the mark 7 is off the visual field of the mark detector 320 (NO in step S1012), the process advances to step S1014. In step S1014, the controller 41 determines whether a region where mark detection is not attempted yet exists in the detection range decided in step S1009. If a region where mark detection is not attempted yet exists in the detection range decided in step S1009 (YES in step S1014), the process returns to step S1010. In step S1010, the controller 41 performs XY driving of the substrate stage 310 such that the region where mark detection is not attempted yet enters the visual field of the mark detector 320. In step S1011, the controller 41 re-executes mark detection.

In step S1014, if mark detection is already performed in the whole detection range, and there is no region where mark detection is not attempted yet (NO in step S1014), the process advances to step S1015. In step S1015, the controller 41 extends the range to perform mark detection to the periphery of the detection range, and performs search of the mark 7. The search of the mark 7 is processing for attempting mark detection by the mark detector 320 near the region set in step S1009. The controller 41 performs XY driving of the substrate stage 310 near the region set in step S1009 such that the region where mark detection is not executed yet enters the visual field of the mark detector 320, and executes mark detection in step S1011 again. If detection of the mark 7 does not succeed even if mark detection processing is repeated an arbitrary number of times for an arbitrary range, it may be judged that alignment processing cannot be continued, and processing for the substrate may be stopped.

An example of alignment according to the first embodiment will be described. In step S1006, the controller 41 detects an edge A and an edge B using a plurality of (here, two) edge detection methods. Assume that the calculated amounts of positional deviation are ΔXY_A and ΔθA, and ΔXY_B and ΔθB.

In step S1007, the controller 41 executes first-stage alignment using, for example, the edge A. In this case, more specifically, the translation mechanism 112 of the prealignment stage 110 is translated by -ΔXY_A, thereby aligning the center of the substrate 60 with the center coordinates of the prealignment stage 110. After that, the rotation stage 111 is rotated by -ΔθA, thereby aligning the notch 64 of the substrate 60 in a predetermined direction.

In step S1008, the controller 41 conveys, using the substrate conveying mechanism 2, the substrate 60 that has undergone first-stage alignment. At this time, the substrate 60 is placed on the substrate stage 310 such that the center of the substrate stage 310 of the processing section 300 (second substrate processing apparatus) matches the center of the substrate 60 and the angle of the notch 64 does not change.

In step S1009, the controller 41 decides the detection range of the mark. Here, assume that a position M (a position when the substrate center is defined as the origin) of the mark 7 formed on the substrate 60 is known. At this time, first-stage alignment by referring to the position of the edge A has been completed, and the center of the substrate 60 and the center of the substrate stage 310 match. Hence, on two-dimensional coordinates with respect to the center of the substrate stage 310 as the origin, a position T_A where the mark 7 is expected to exist matches the position M of the mark 7. On the other hand, referring to the edge B in this state, on two-dimensional coordinates with respect to the center of the substrate stage 310 as the origin, a position T_B where the mark 7 is expected to exist can be expressed, using ΔXY_A, ΔθA, ΔXY_B, and ΔθB, as

$$T\_B(x, y) = R(\Delta\theta B - \Delta\theta A)(\Delta XY\_B - \Delta XY\_A) \quad\quad ...(1)$$

Where,

$$R(\theta) = \begin{pmatrix} cos\theta & -sin\theta \\ sin\theta & cos\theta \end{pmatrix}$$

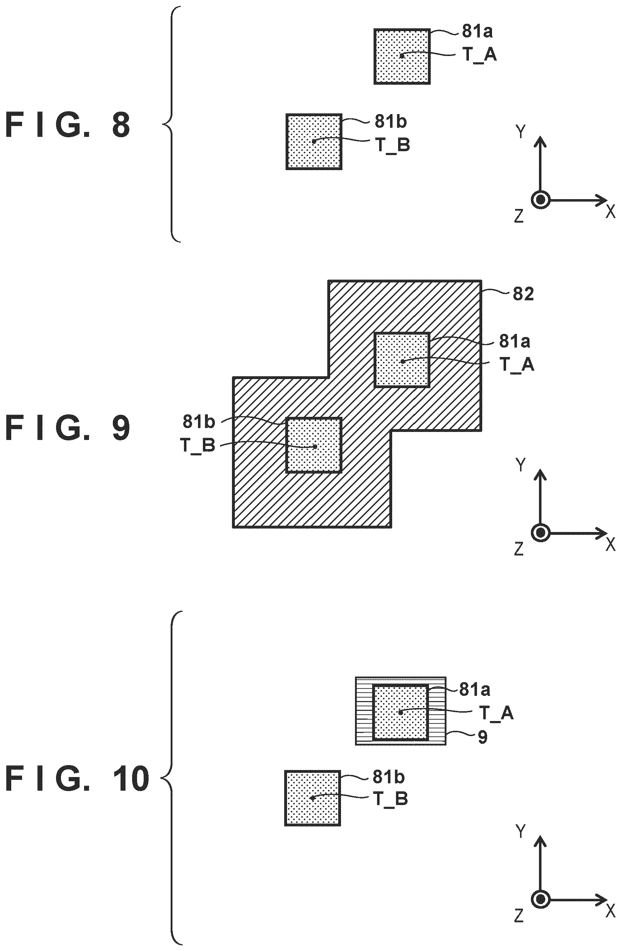

The controller 41 decides the mark detection range such that it includes at least the mark expectation positions T_A and T_B calculated based on the amounts of positional deviation obtained from the edge A and the edge B. In fact, the controller 41 sets mark expectation ranges 81a and 81b that are ranges where the mark is expected to exist such that at least a range to cover a region of the size of the mark 7 is included. In Fig. 8, the size of each of the mark expectation ranges 81a and 81b matches the size of the mark 7. In Fig. 8, the mark expectation ranges 81a and 81b are each set to the minimum size. However, as shown in Fig. 9, a range including a vicinity region 82 of the mark expectation ranges 81a and 81b may be set to the detection range.

In step S1010, the controller 41 translates the substrate stage 310 such that a decided mark expectation range 81 (81a or 81b) enters the visual field of the mark detector 320. Here, processing in a case where the mark expectation range 81a enters the visual field of the mark detector 320 will be described. If movement of the substrate stage 310 is completed in step S1010, in step S1011, the controller 41 detects the mark. Here, as shown in Fig. 10, the controller 41 performs mark detection in a mark detection execution range 9. The mark detection execution range 9 is a range matching the size of the visual field of the mark detector 320.

In step S1012, the controller 41 determines whether the mark exists in the mark detection execution range 9. A case where it is determined in step S1012 that no mark exists in the mark detection execution range 9 will be described. If mark detection fails, in step S1014, the controller 41 determines whether a mark detection non-execution region exists. In the example shown in Fig. 10, the mark expectation range 81a is a region that is included in the mark detection execution range 9 and has undergone detection. On the other hand, mark detection is not executed for the mark expectation range 81b. Hence, in this case, the process returns to step S1010.

In step S1010, the controller 41 drives the substrate stage 310 such that the mark expectation range 81b where detection is not executed enters the visual field of the mark detector 320, and continues subsequent processing. After that, in step S1012, if mark detection fails again, the process advances to step S1014 again. However, mark detection is already executed for the mark expectation ranges 81a and 81b. For this reason, in this case, the process advances to step S1015. In step S1015, the controller 41 repeats, for the vicinity region 82, driving of the substrate stage 310 and steps S1011 to S1015 of mark detection such that mark detection is attempted. If mark detection does not succeed even if mark detection is executed in the whole vicinity region 82, or if mark detection does not succeed even if it is repeated a predetermined number of times, the processing may be interrupted, considering that alignment processing for the substrate fails.

According to the above-described alignment method, if the registration mark does not enter the visual field of the measuring device, the time required for mark detection can be shortened. This can simultaneously implement accurate registration and high throughput.

<Second Embodiment>

An alignment method according to the second embodiment will be described next. The second embodiment is different from the first embodiment in the method of deciding a mark detection position and range in step S1009. Other same components are denoted by the same reference numerals, and a description thereof will be omitted. Also, the configuration of a registration apparatus according to this embodiment is the same as in Fig. 1, and a description thereof will be omitted.

In step S1009 of the first embodiment, based on the theoretical position of the mark 7 and the plurality of amounts ($\Delta\theta$ and $\Delta XY$) of positional deviation obtained in step S1006, a plurality of candidates (mark position candidates) of the position where the mark 7 is assumed to exist by calculation are calculated. After that, a region including the mark position candidates is decided as the detection range. However, the plurality of amounts of positional deviation obtained in step S1006 may include a position of low accuracy, which is calculated from an edge detection result of low accuracy. For example, in the substrate shown in Fig. 5 in which the silicon substrate 621 is laminated onto the glass substrate 620, a foreign substance may adhere to the glass substrate 620, or an adhesive used for laminating may protrude. In this case, if the amounts of positional deviation are calculated based on the edge 623 shown in Fig. 5, practically impossible amounts ($\Delta\theta$ and $\Delta XY$) of positional deviation may be calculated. If a region including mark candidate positions calculated based on the amounts of positional deviation is decided as the mark detection range, a region where the mark should not exist is wastefully measured.

In the second embodiment, when calculating mark candidate positions from the calculated amounts ($\Delta\theta$ and $\Delta XY$) of positional deviation, a predetermined criterion is provided to cope with this situation. As the predetermined criterion, for example, the standard value of a substrate size or the standard value (or actual value) of a laminating error in a case of a laminated substrate can be used. In a case of a laminated substrate, from the standard value of the laminating error and the position of a mark 7 on the substrate, maximum values (maximum errors) that the translation and rotation errors of the position of the mark 7 can take due to the laminating error can be calculated for each of $\Delta\theta$ and $\Delta XY$. For example, assume that when an amount of positional deviation calculated from the edge of a laminated substrate (for example, the edge of a glass substrate) is used as a reference, an amount of positional deviation calculated from another edge (for example, the edge of a silicon substrate) has a difference more than a theoretical maximum error. In this case, the amount of positional deviation calculated from the edge of the silicon substrate is corrected based on the maximum error. For example, if a position calculated from the edge of the glass substrate is used as the reference, translation ($\Delta XY$) of a position calculated from the edge of the silicon substrate is expressed as a vector, and it may be corrected to the position where the magnitude of the vector is reduced to the same as the maximum error while keeping the direction of the vector unchanged. This means that only the direction of the mark expectation position is use to decide the mark detection position. Also, if the error of translation is more than the maximum error, but the rotation error is less than the maximum error, the mark candidate position may be calculated using only the rotation error without considering the translation (assuming that there is no translation component of the laminating error). The correction method based on the maximum error is arbitrary.

According to this embodiment, the information of an amount of positional deviation of low detection accuracy is limitedly used, thereby preventing a wasteful mark detection operation and improving productivity as compared to the first embodiment.

<Third Embodiment>

An alignment method according to the third embodiment will be described next. The third embodiment is different from the first embodiment in that which position and range among mark detection positions and ranges decided in step S1009 should be preferred to detect a mark is defined. More specifically, in steps S1010 and S1015, a substrate stage 310 is driven to a region preferred to detect a mark. Other same components are denoted by the same reference numerals, and a description thereof will be omitted. Also, the configuration of a registration apparatus according to this embodiment is the same as in Fig. 1, and a description thereof will be omitted.

In the first embodiment, among mark detection positions and ranges decided in step S1009, a position where a mark exists in terms of calculation is preferred. However, if there exist a plurality of positions where a mark exists in terms of calculation, which one of the positions should be preferred is not defined. If there exist a plurality of positions where the mark exists in terms of calculation, driving of the substrate stage 310 and mark detection need to be performed a plurality of times to complete mark detection in all the regions. If mark detection succeeds at least once, the process can advance to the next step. However, the larger the number of times of mark detection is, the longer the time taken is. Hence, it is disadvantageous in productivity of the substrate processing apparatus. Hence, which position and range among the decided mark detection positions and ranges should be preferred to detect a mark is defined such that mark detection is completed in a small number of times of mark detection.

To decide which one of a plurality of calculated mark candidate positions should be preferred, an accuracy evaluation value is calculated for each of a plurality of amounts of positional deviation used to calculated the mark candidate positions, and a candidate position is decided based on the accuracy evaluation value. The higher the accuracy evaluation value of a position is, the higher the accuracy of first-stage alignment at the position is expected to be. For this reason, the expectation value that a mark 7 is in the visual field of a mark detector 320 is high. For example, the accuracy evaluation value of an amount of positional deviation is calculated from the accuracy evaluation value of the outer shape (received light waveform) of a substrate used to calculate the amount of positional deviation. The size and the notch shape of the substrate of the processing target are defined by a standard, and its ideal shape is known. It is therefore possible to calculate a measurement accuracy from the difference between the ideal shape of the substrate and the actually measured received light waveform. If three or more amounts of positional deviation are obtained using three or more types of edge detection methods, the gravity of the substrate center positions may be calculated, and the evaluation value may be set higher for a position close to the gravity. Alternatively, the measurement accuracy evaluation value may be calculated using an arbitrary method or a combination of arbitrary methods.

According to this embodiment, a mark detection position calculated from an amount of positional deviation of a high detection accuracy is preferentially detected, and thereby an effect of shortening total time required for mark detection and improving productivity as compared to the first embodiment is expected.

<Fourth Embodiment>

An alignment method according to the fourth embodiment will be described next. The fourth embodiment is different from the first embodiment in that in step S1009 for the second or subsequent substrate, the calculation method or calculation condition of the mark detection position and range is changed. To change the calculation method or calculation condition, a mark 7 is measured in step S1011 of second-stage alignment, and the change is executed based on a position error calculated to execute alignment in step S1013. Other same components are denoted by the same reference numerals, and a description thereof will be omitted. Also, the configuration of a registration apparatus according to this embodiment is the same as in Fig. 1, and a description thereof will be omitted.

Generally, in a case where prealignment (first-stage alignment) is performed by detecting the outer shape of a substrate, and second-stage alignment is then performed by detecting a mark on the substrate, the accuracy of second-stage alignment is higher than that of prealignment. That is, the position finally aligned in the second-stage alignment is the final target position that even prealignment should aim at. Here, it is possible to calculate the difference between each of a plurality of amounts of positional deviation calculated at the time of prealignment and the position obtained by mark detection in second-stage alignment. If the difference of the position is assumed to have the same tendency in, for example, each lot to perform substrate processing, the difference can be corrected in advance when deciding the mark detection position and range from the amount of positional deviation obtained at the time of prealignment.

A flowchart of a registration method according to the fourth embodiment is the same as the flowchart of the first embodiment shown in Fig. 7. Particularly, in substrate processing for the first substrate, processing up to step S1013 is the same as in the first embodiment.

In step S1013, a controller 41 calculates the errors ΔXY and Δθ) of translation and rotation with respect to the target position of a substrate 60 from the detection result of the mark 7 by a mark detector 320. The controller 41 then calculates the difference (correction offset) between the calculated error and each of a plurality of amounts of positional deviation calculated in first-stage alignment, and stores, in a storage unit 42, the correction offset for each edge detection method used to calculate the amount of positional deviation. The correction offset is a value that implements alignment of the same accuracy as that after second-stage alignment is executed when position correction by the correction offset is further performed for each amount of positional deviation calculated in first-stage alignment. When performing processing of the second or subsequent substrate, in step S1009, the calculation method of the mark detection position and range is changed using the correction offset for each edge detection method stored in the storage unit 42. More specifically, when calculating a mark detection position, coordinates to which the correction offset of a corresponding edge detection method is added are calculated. If the correction offsets have the same tendency for the substrates, the decision accuracy of the mark detection position calculated in consideration of the correction offsets improves, and a situation in which the mark 7 is not in the visual field of the mark detector 320 can easily be avoided. However, at this time, if the correction offsets are values of different tendencies for the substrates, the decision accuracy of the mark detection position may be lowered. Hence, the accuracy of the correction offset may be evaluated, and use of a correction offset of low accuracy may be inhibited. If it is assumed that the correction offsets are the same for the substrates, amounts of positional deviation further corrected by adding the correction offsets to the amounts of positional deviation should match in all methods even if the amount of positional deviation calculated for each edge detection method has a difference. Reversely, a correction offset for which the position does not match when the same correction is performed can be judged as a component that varies for each substrate. Thus, a correction offset having a component that varies for each substrate may be excluded from use at the time of calculation of the mark detection position.

According to this embodiment, an accurate second-stage alignment result is used in substrate processing of the second and subsequent time. This makes it possible to decide the mark detection position more accurately as compared to a case where the mark detection position is decided based on information that can be obtained from a single substrate.

The above-described embodiments are merely examples. The present invention is not limited to the above-described configurations and shapes, and changes and modifications can appropriately be made without departing from the scope of the present invention. For example, two or more outer shape detection devices may be formed in a first substrate processing apparatus, and these may be of different types. Different edge detection methods may be applied to pieces of substrate outer shape information detected by the outer shape detection devices.

<Embodiment of Lithography Apparatus>

An embodiment in which the above-described substrate processing apparatus 1 is formed as a lithography apparatus will be described. The lithography apparatus is an apparatus that is employed in a lithography step that is a manufacturing step of a semiconductor device or a liquid crystal display device and forms a pattern on a substrate. An example of the lithography apparatus is an exposure apparatus that transfers a pattern of an original onto a substrate by exposing the substrate through the original. A description will be made below while exemplifying an exposure apparatus as a lithography apparatus.

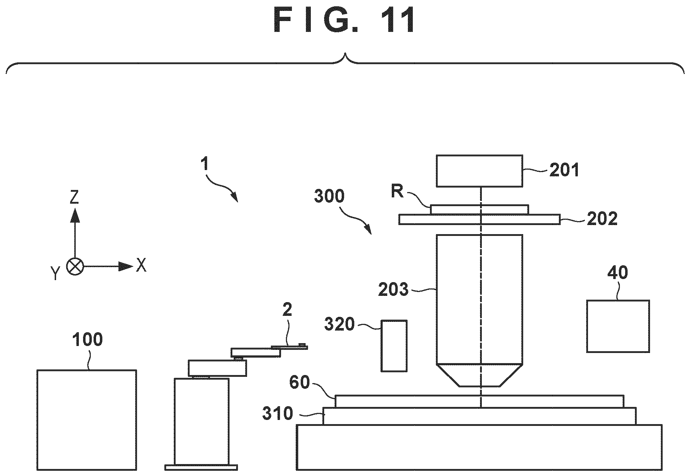

Fig. 11 is a view showing the configuration of a substrate processing apparatus 1 as an exposure apparatus. The substrate processing apparatus 1 as an exposure apparatus transfers the pattern of an original R onto a substrate 60 by, for example, a step-and-repeat method or a step-and-scan method. As shown in Fig. 1, the substrate processing apparatus 1 includes a prealignment unit 100, a substrate conveying mechanism 2, a processing section 300, and a control device 40. Here, the processing section 300 is configured as a patterning device that forms a pattern on the substrate 60. More specifically, as shown in Fig. 11, the processing section 300 can include an illumination optical system 201, an original stage 202, a projection optical system 203, a substrate stage 310, and a mark detector 320.

The prealignment unit 100 performs prealignment of the substrate 60 using the same method as in the first embodiment. That is, in the prealignment step, the prealignment unit 100 calculates the amount of positional deviation of the substrate 60 in accordance with each of a plurality of methods.

The prealigned substrate 60 is conveyed onto the substrate stage 310 by the substrate conveying mechanism 2. The control device 40 is configured to perform general control of control processing and exposure processing described in the first to fourth embodiments. Prior to exposure processing, the control device 40 performs fine alignment for the substrate 60 on the substrate stage 310. Fine alignment includes deciding the detection range of a mark formed on the substrate 60 based on the plurality of amounts of positional deviation calculated in the prealignment step, as described in the first embodiment.

<Embodiment of Article Manufacturing Method>

A lithography apparatus as described above can be used to execute an article manufacturing method for manufacturing various articles (a semiconductor IC element, a liquid crystal display element, a MEMS, and the like). The article manufacturing method according to the embodiment of the present invention is suitable to manufacture, for example, an article such as a device (a semiconductor element, a magnetic storage medium, a liquid crystal display element, or the like). The article manufacturing method includes a processing step of processing a substrate by the above-described substrate processing method (substrate processing apparatus), a forming step of forming a pattern on the substrate that has undergone the processing step, and a manufacturing step of manufacturing an article from the substrate that has undergone the forming step. The processing step may be understood as a step of performing prealignment processing as processing of the substrate. Furthermore, the article manufacturing method can include other known processes (oxidation, deposition, vapor deposition, doping, planarization, etching, resist removal, dicing, bonding, packaging, and the like). The article manufacturing method according to this embodiment is advantageous in at least one of the performance, quality, productivity, and production cost of the article, as compared to conventional methods.

Other Embodiments

Embodiment(s) of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit (ASIC)) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)™), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

**Claims**

1. A substrate processing method comprising:

   performing prealignment of a substrate; and
   performing fine alignment of the substrate after the performing the prealignment,
   wherein the performing the prealignment includes calculating a plurality of amounts of positional deviation of the substrate in parallel by a plurality of methods (S1006), and
   the performing the fine alignment includes deciding a detection range of a mark formed on the substrate based on the plurality of calculated amounts of positional deviation (S1009).

2. The method according to claim 1, wherein

   the performing the prealignment includes performing alignment of the substrate based on one of the plurality of amounts of positional deviation, and
   the performing the fine alignment includes:

      performing alignment of the substrate based on the detection range (S1010) and, after that, detecting the mark using a scope (S1011); and
      if the mark detection fails, moving the substrate such that the mark detection is performed in a range where the mark detection is not performed yet in the detection range and, after that, re-executing the mark detection using the scope (S1012 NO - S1014 YES - S1010).

3.  The method according to claim 2, wherein in the performing the fine alignment, if the mark detection fails, and the mark detection is already performed in the whole detection range, the range to perform the mark detection to a periphery of the detection range (S1015).

4.  The method according to any one of claims 1 to 3, wherein in the deciding, a plurality of mark candidate positions that are candidates of an existence position of the mark are calculated based on a designed position of the mark and the plurality of amounts of positional deviation, and a region including the plurality of mark position candidates is decided as the detection range.

5.  The method according to any one of claims 1 to 4, wherein

    the amounts of positional deviation include an amount of translation and an amount of rotation of the substrate, and
    in the deciding, the detection range is decided based on a maximum value that an error of each of the amount of translation and the amount of rotation can take.

6.  The method according to claim 2 or 3, wherein in the performing the fine alignment, the mark detection is performed with priority on a range where the mark exists in terms of calculation in the detection range.

7.  The method according to claim 2 or 3, wherein in the performing the fine alignment, an accuracy evaluation value is calculated for each of the plurality of amounts of positional deviation, and the mark detection is performed with priority on a range where the accuracy evaluation value is high in the detection range.

8.  The method according to any one of claims 1 to 7, wherein based on a result of the mark detection performed for a first substrate in the performing the fine alignment and the plurality of amounts of positional deviation calculated in the performing the prealignment, a calculation method or calculation condition of the detection range for a second substrate to be processed after the first substrate is changed.

9.  A substrate processing apparatus (1) comprising:

    a prealignment device (100) configured to perform prealignment of a substrate; and
    a processing section (300) configured to process the substrate that has undergone the prealignment in the prealignment device,
    wherein the processing section includes:

    a substrate stage (310) configured to hold and move the substrate; and
    a detection unit (320) configured to detect a mark formed on the substrate,
    the prealignment device calculates a plurality of amounts of positional deviation of the substrate in parallel by a plurality of methods, and
    the processing section is configured to decide a detection range, by the detection unit, of the mark on the substrate held by the substrate stage based on the plurality of calculated amounts of positional deviation.

10. The apparatus according to claim 9, wherein

    the substrate processing apparatus is a lithography apparatus configured to form a pattern on the substrate, and
    the processing section is configured as a patterning device that forms the pattern on the substrate.

11. An article manufacturing method comprising:

    processing a substrate using a substrate processing method defined in any one of claims 1 to 8;
    forming a pattern on the substrate that has undergone the processing; and
    manufacturing an article from the substrate that has undergone the forming.

# F I G. 1

FIG. 2

FIG. 3

LIGHT AMOUNT

OUTSIDE ← → CENTER

R

FIG. 4

LIGHT AMOUNT

OUTSIDE ← → CENTER

R

13

# F I G. 5

# F I G. 6

# FIG. 7

START

| CONTROL BRIGHTNESS OF LIGHT SOURCE | S1001 |

| LOAD SUBSTRATE INTO PREALIGNMENT UNIT | S1002 |

| START θ ROTATION OF SUBSTRATE | S1003 |

| STORE OUTPUT FROM LIGHT RECEIVING ELEMENT IN STORAGE UNIT | S1004 |

| END θ ROTATION OF SUBSTRATE | S1005 |

| OBTAIN AMOUNTS OF POSITIONAL DEVIATION BY PLURALITY OF METHODS | S1006 |

| PERFORM FIRST-STAGE ALIGNMENT | S1007 |

| CONVEY SUBSTRATE TO PROCESSING SECTION | S1008 |

| DECIDE DETECTION RANGE OF MARK | S1009 |

| DRIVE STAGE | S1010 |

| DETECT MARK | S1011 |

S1012

SUCCEED MARK DETECTION?

YES → DRIVE ALIGNMENT STAGE → END S1013

NO

S1014

IS THERE REGION WHERE DETECTION IS NOT EXECUTED ?

YES

NO

| DRIVE SEARCH STAGE | S1015 |

F I G. 8

F I G. 9

F I G. 10

# FIG. 11

EP 4 644 995 A2